Europäisches Patentamt

European Patent Office

Office européen des brevets

(11) Publication number: **0 585 972 A2**

# EUROPEAN PATENT APPLICATION

(21) Application number: **93117585.5**

(22) Date of filing: **20.12.89**

(51) Int. Cl.5: **H01L 21/314**, H01L 21/28

This application was filed on 29 - 10 - 1993 as a divisional application to the application mentioned under INID code 60.

(30) Priority: **20.12.88 JP 321186/88**

(43) Date of publication of application:
**09.03.94 Bulletin 94/10**

(60) Publication number of the earlier application in accordance with Art.76 EPC: **0 384 031**

(84) Designated Contracting States:
**DE FR GB**

(71) Applicant: **MATSUSHITA ELECTRIC INDUSTRIAL CO., LTD.**
**1006, Ohaza Kadoma**
**Kadoma-shi, Osaka 571(JP)**

(72) Inventor: **Hori, Takashi**
**1-1-508, Chiyoda-cho**
**Takatsuki-Shi, Osaka(JP)**

(74) Representative: **Marx, Lothar, Dr. et al**
**Patentanwälte Schwabe, Sandmair, Marx**
**Stuntzstrasse 16**
**D-81677 München (DE)**

(54) **A semiconductor device and a method for the production of an insulated film used in this device.**

(57) A semiconductor device is disclosed which comprises a semiconductor substrate and an insulating film disposed on the substrate. The insulating film is a nitride oxide film prepared by nitriding a thermal oxide film, which has been formed on the substrate, in an atmosphere of nitriding gas. The nitriding is conducted for a nitridation time of $10^{6.6-T_N/225}$ seconds or shorter wherein $T_N$ is the nitridation temperature in degree centigrade, or conducted so as to have a nitrogen concentration of about 8 atomic % or less, at least in the vicinity of the interface between the nitride oxide film and the substrate. Also disclosed is a method for the production of the semiconductor device.

Fig. 1e

Fig. 1f

Fig. 1a

Fig. 1b

Fig. 1c

Fig. 1d

## BACKGROUND OF THE INVENTION

1. Field of the invention:

The present invention relates to a minute metal oxide semiconductor field-effect device (hereinafter referred to as MOS device) and a method for the production of a high-performance insulating film used in the MOS device.

2. Description of the prior art:

Previously, a thermal oxide film formed on a semiconductor substrate was used as the gate oxide film for MOS devices. In a minute MOS device using a conventional thermal oxide film as the gate insulating film, deterioration of mobility caused by an increase in the electric field acting perpendicular to the channel has become a serious problem. Since the deterioration of mobility reduces the current driving capability and switching speed of the MOS device, it has been one of the major factors working against the further miniaturization of the MOS device.

On the other hand, it has been studied among some researchers to use a nitride oxide film instead of the thermal oxide film in a minute MOS device for improvement of reliability such as dielectric strength. At the present point of time, however, the nitride oxide film can only provide a very low mobility as compared to the thermal oxide film, which has been one of the serious problems preventing the nitride oxide film from coming in practice.

## SUMMARY OF THE INVENTION

A semiconductor device of this invention, which overcomes the above-discussed and numerous other disadvantages and deficiencies of the prior art, comprises a semiconductor substrate and an insulating film disposed on the substrate, wherein the insulating film is a nitride oxide film prepared by nitriding a thermal oxide film, which has been formed on the substrate, in an atmosphere of nitriding gas for a nitridation time of $10^{6.6-T_N/225}$ seconds or shorter wherein $T_N$ is the nitridation temperature in degree centigrade.

In a preferred embodiment, the nitride oxide film is used as a gate insulating film.

Another semiconductor device of this invention comprises a semiconductor substrate and an insulating film disposed on the substrate, wherein the insulating film is a nitride oxide film prepared by nitriding a thermal oxide film, which has been formed on the substrate, so as to have a nitrogen concentration of about 8 atomic % or less, at least in the vicinity of the interface between the nitride oxide film and the substrate.

In a preferred embodiment, the nitride oxide film is used as a gate insulating film.

A method for the production of a semiconductor device, which overcomes the above-discussed and numerous other disadvantages and deficiencies of the prior art, comprises the steps of forming a thermal oxide film on the substrate and nitriding said thermal oxide film in an atmosphere of nitriding gas for a nitridation time of $10^{6.6-T_N/225}$ seconds or shorter wherein $T_N$ is the nitridation temperature in degree centigrade.

In a preferred embodiment, rapid heating by means of radiation is used in the nitriding step.

Another method for the production of a semiconductor device comprises the steps of forming a thermal oxide film on the substrate and nitriding the thermal oxide film in an atmosphere of nitriding gas so as to have a nitrogen concentration of about 8 atomic % or less, at least in the vicinity of the interface between the nitride oxide film and the substrate.

In a preferred embodiment, rapid heating by means of radiation is used in said nitriding step.

Thus, the invention described herein makes possible the objectives of (1) providing a semiconductor device which has a submicron MOS gate insulating film with superior performance to a thermal oxide film; and (2) providing a method for the production of such a semiconductor device.

According to the present invention, it is possible to form a nitride oxide film with a high mobility as well as markedly improved resistance to mobility deterioration caused by a high vertical electric field, in a very short time. Also, redistribution of the impurities formed in the semiconductor substrate can be prevented. Moreover, effective mobility in a high electric field can be improved as compared to thermal oxide films.

The semiconductor device of the invention exhibits superior electrical properties when operated at gate driving voltages ($V_G$ - $V_T$) which give an electric field (E) across the nitride oxide film at or above 2 MV/cm, especially at or above 4 MV/cm. The electric filed (E) is preferably at or below 7 MV/cm.

## BRIEF DESCRIPTION OF THE DRAWINGS

This invention may be better understood and its numerous objects and advantages will become apparent to those skilled in the art by reference to the accompanying drawings as follows:

Figures 1a to 1f are schematic diagrams showing the production of a semiconductor device of this invention.

Figure 2 is a diagram showing the nitrogen profile in various nitride oxide films measured by Auger spectroscopy.

Figure 3a is a graph of the drain current $I_D$ against the gate driving voltage $V_G$-$V_T$ at room temperature with respect to a 7.7 nm thick oxide film and a nitride oxide film (NO) formed by nitriding for 60 seconds at 950°C.

Figure 3b is a graph of the transconductance $g_m$ against the gate driving voltage $V_G$-$V_T$ at room temperature with respect to a 7.7 nm thick oxide film and a nitride oxide film (NO) formed by nitriding for 60 seconds at 950°C.

Figure 4a is a graph of the drain current $I_D$ against the gate driving voltage $V_G$-$V_T$ at 82 K with respect to a 7.7 nm thick oxide film and a nitride oxide film (NO) formed by nitriding for 60 seconds at 950°C.

Figure 4b is a graph of the transconductance $g_m$ against the gate driving voltage $V_G$-$V_T$ at 82 K with respect to a 7.7 nm thick oxide film and a nitride oxide film (NO) formed by nitriding for 60 seconds at 950°C.

Figures 5a and 5b are of characteristic curves showing the saturation current at 82 K with respect to an oxide film and a nitride oxide film (NO) formed by nitriding for 60 seconds at 950°C, respectively.

Figure 6a is a graph of the maximum field effect mobility $\mu_{FEmax}$ at room temperature, against the nitridation time with respect to various nitride oxide films.

Figure 6b is a graph of the field effect mobility $\mu_{FE}$ at the time of formation of a high vertical electric field of 3.3 MV/cm within the insulating film, against the nitridation time with respect to various nitride oxide films used as the insulating film.

Figures 7a and 7b are graphs of the effective mobility $\mu_{eff}$ in a high vertical electric field of 3.3 MV/cm at room temperature and at 82 K, respectively, against the nitridation time.

Figure 8 is a graph of the maximum nitridation time $t_N$ which accomplishes the improvement of effective mobility as compared to the oxide film, against the nitridation temperature $T_N$.

Figure 9 is a graph of the effective mobility $\mu_{eff}$ in a high vertical electric field of 4 MV/cm within the insulating film, which is measured by Auger spectroscopy, against the nitrogen concentration $[N]_{int}$ in the vicinity of the interface between the insulating film and the substrate.

## DESCRIPTION OF THE PREFERRED EMBODIMENTS

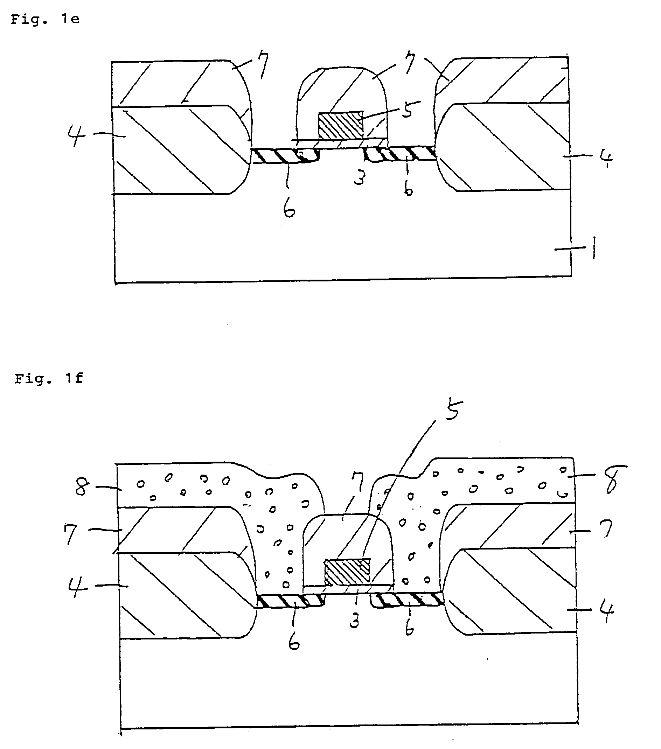

Figures 1a to 1f shows the production of a semiconductor device of this invention. The semiconductor device is of an MOS type, which is produced as follows.

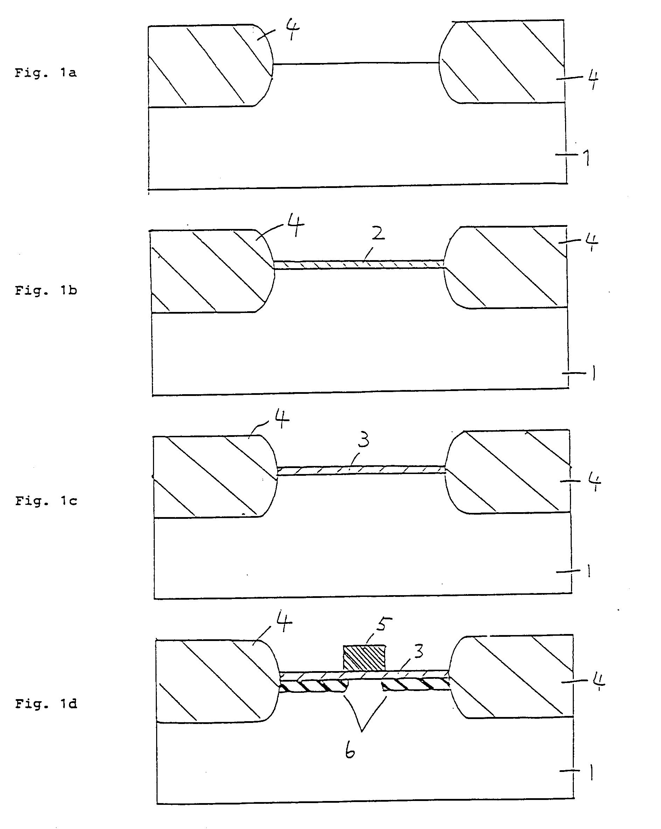

First, on a semiconductor substrate **1** made of silicon, an isolation insulating film **4** is formed by, for example, local oxidation of silicon (LOCOS), as shown in Figure 1a. Then, a thermal oxide film **2** is formed on the semiconductor substrate **1** as shown in Figure 1b. The thermal oxide film **2** is converted into a nitride oxide film **3**, as shown in Figure 1c, by heating in an atmosphere of ammonia gas for a short time by the use of a short-time heating furnace.

Thereafter, material for the gate electrode, such as polysilicon, is deposited on the entire surface and etched to form a gate electrode **5**. Then, source and drain regions **6** are formed in a self-alignment manner by the use of an ion injection method as shown in Figure 1d.

Next, an interlayer insulating film **7** is deposited on the entire surface, followed by the formation of contact holes for the source and drain regions **6** as shown in Figure 1e, and then aluminum electrodes **8** are formed as shown in Figure 1f, resulting in an MOS device of this invention.

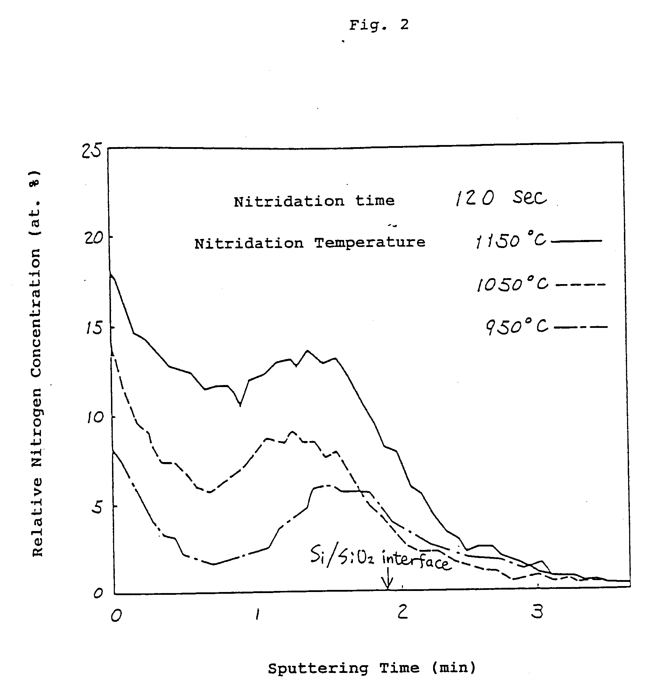

Figure 2 shows the nitrogen profiles measured by Auger spectroscopy in the nitride oxide films formed by nitriding for 120 seconds at temperatures of 950°C, 1050°C, and 1150°C, respectively. The samples used for the measurements correspond to the nitride oxide film **3** shown in Figure 1c. The nitride oxide film has nitride oxide layers formed in the vicinity of the surface of the film, as well as in the vicinity of the interface between the insulating film and the semiconductor substrate, and a higher nitrogen concentration is obtained at a higher nitridation temperature. It can be seen from Figure 2 that a relatively high concentration of nitrogen can be introduced into the insulating film even with such a short nitridation time.

Next, MOS device samples having the gate length and gate width both 100 $\mu$m were produced as shown in Figure 1f, and their electrical characteristics were examined. The thickness of the gate oxide film formed was 7.7 nm.

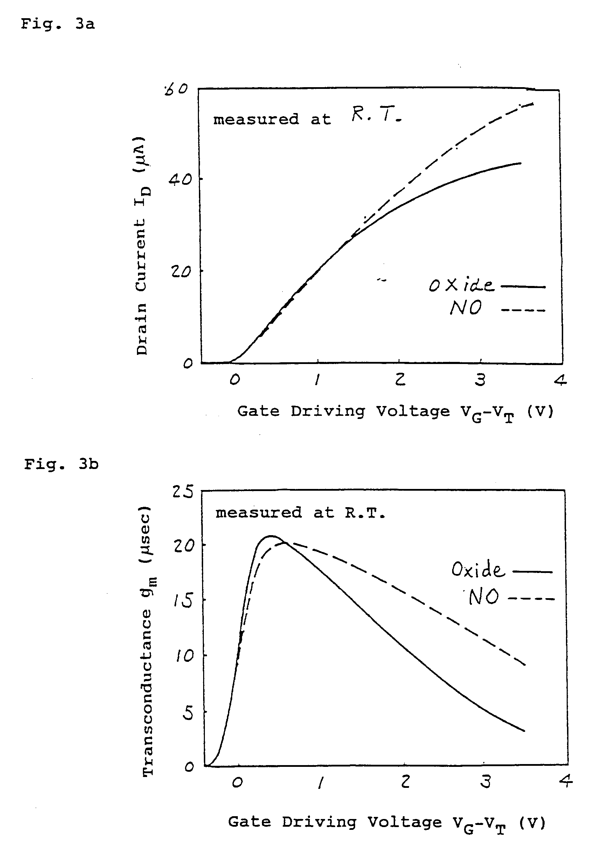

In Figures 3a and 3b, respectively, the drain current $I_D$ and transconductance $g_m$ at the room temperature of the 7.7 nm thick oxide film and of the nitride oxide film (NO) formed by nitriding for 60 seconds at 950°C are plotted against the gate driving voltage $V_G$-$V_T$. In the case of the oxide film, the transconductance drops markedly and the drain current is low at high gate driving voltages (1.5 V or higher) because of the significant deterioration of the mobility caused by a high vertical electric field. On the other hand, in the case of the nitride oxide film (NO), it can be seen that the maximum transconductance occurring at relatively low driving voltages (approximately 0.5 to 1 V) is almost as great as that of the oxide film, while marked improvement is achieved with respect to the deterioration of transconductance as observed in the oxide film at high gate driving voltages (1.5 V or higher), thus resulting in a very large drain current.

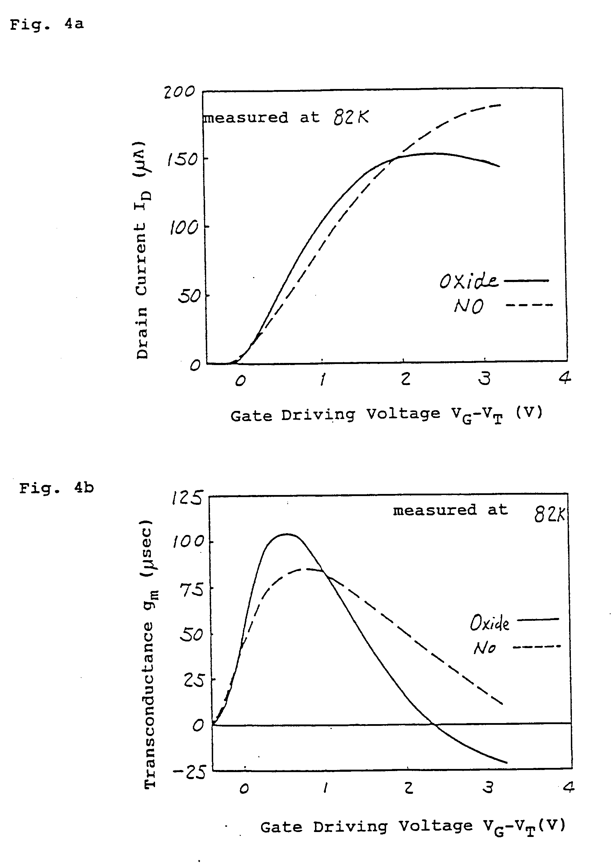

In Figures 4a and 4b, respectively, the drain current $I_D$ and transconductance $g_m$ at 82 K of the same samples as shown in Figures 3a and 3b are plotted against the gate driving voltage $V_G$-$V_T$. In the case of the oxide film, the transconductance drops markedly at high gate driving voltages (1.5 V or higher) and the drain current is low as at room temperature. In addition, the oxide film shows a negative transconductance in which the drain current decreases as the gate driving voltage is increased. This is because the deterioration of mobility caused by a high vertical electric field becomes more appreciable as the temperature lowers. On the other hand, in the case of the nitride oxide film (NO), while the maximum transconductance occurring at relatively low driving voltages (approximately 0.5 to 1 V) is slightly smaller than that of the oxide film, the negative transconductance as observed in the oxide film is not present, thus resulting in a larger drain current than the oxide film at high gate driving voltages (1.5 V or higher).

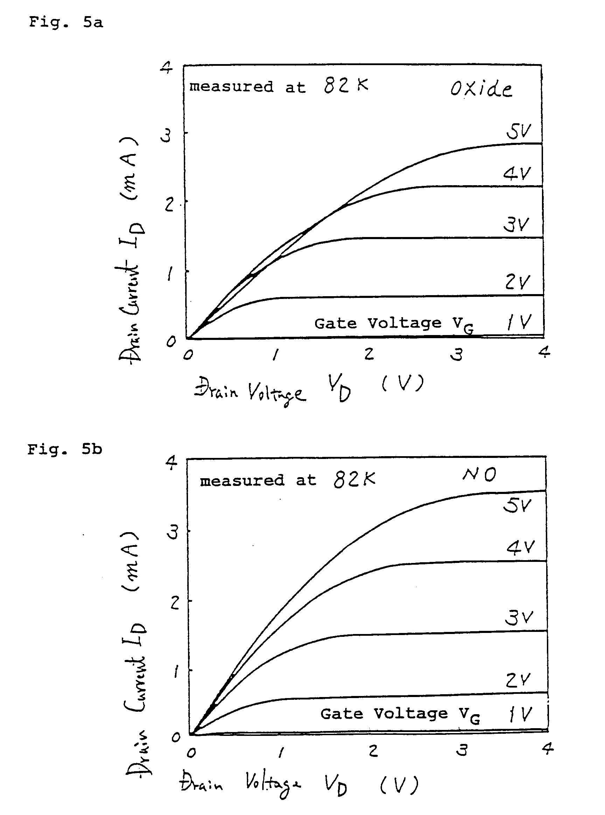

Such a remarkable improvement in performance can also be observed in the saturation current characteristics. Figures 5a and 5b show the saturation current characteristics at 82 K of the oxide film and the nitride oxide film (NO) formed by nitriding for 60 seconds at 950°C, respectively. In the case of the oxide film, the transconductance is extremely small and the drain current is low at particularly high gate driving voltages (3 V or higher). This is caused because of the aforementioned negative transconductance inherent in the oxide film. On the other hand, in the case of the nitride oxide film (NO), it can be seen that the significant improvement is achieved with respect to the deterioration of transconductance at particularly high gate driving voltages (3 V or higher), thus resulting in a very large drain current.

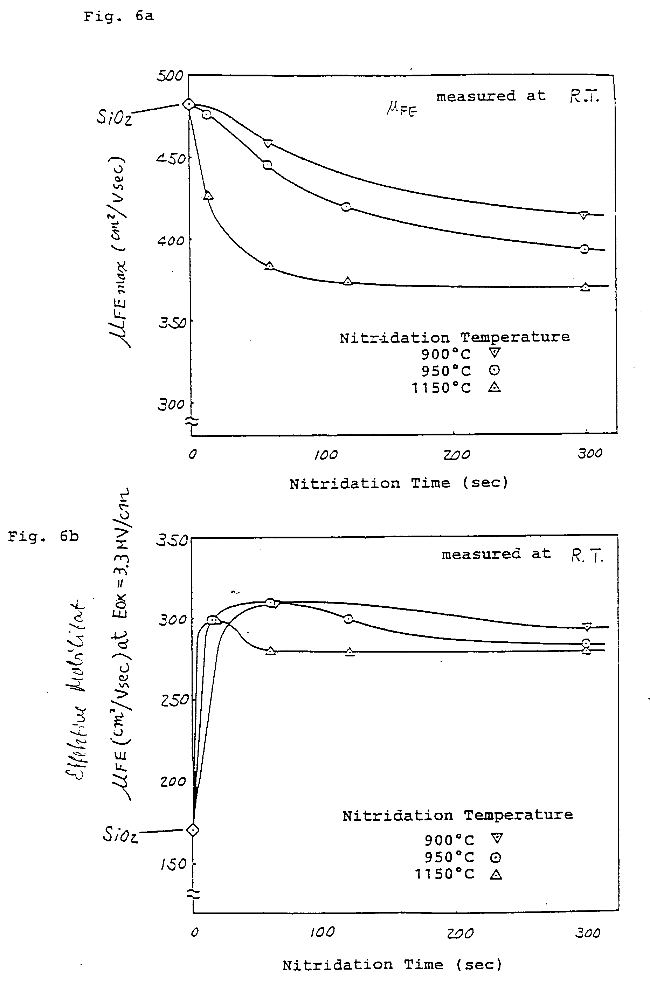

In Figures 6a and 6b, respectively, the maximum field effect mobility at room temperature and the field effect mobility at the time of formation of a high vertical electric field of 3.3 MV/cm within the insulating film are plotted against the nitridation time for examination of their dependency on nitriding conditions. The field effect mobility $\mu_{FE}$ is defined as follows:

$$\mu_{FE} = \frac{L}{W} \cdot \frac{1}{V_D} \cdot \frac{1}{C_i} \cdot \frac{\partial I_D}{\partial (V_G - V_T)}$$

where L is the channel length, W is the channel width, $V_D$ is the drain voltage, $C_i$ is the capacitance per unit area of the insulating film, $I_D$ is the drain current, and $V_G$-$V_T$ is the gate driving voltage. The field effect mobility $\mu_{FE}$ is considered as a mobility for small signals and therefore significantly reflects the tendency of a mobility at each voltage $V_G$-$V_T$. It can be seen from Figure 6a that the maximum field effect mobility at relatively low driving voltages (approximately 0.5 to 1 V) is the greatest in the case of the oxide film and decreases as the nitriding proceeds, i.e., as the nitridation time becomes longer or as the nitridation temperature increases. On the other hand, it can be seen from Figure 6b that the field effect mobility in a high vertical electric field of 3.3 MV/cm increases markedly even with a very short nitridation time. For example, with nitriding for only 15 seconds at 950°C, the obtained mobility in a high electric field is approximately two times greater than that obtained in the case of the oxide film. Even when the nitriding is continued for a longer time, the improved field effect mobility in a high electric field shows very little change. From the fact that nitriding provides improved resistance to the deterioration of field effect mobility in a high electric field inherent in the oxide film, it will be appreciated that the nitride oxide layer formed near the interface by nitriding as shown in Figure 2 greatly contributes to the substantial improvement of the above-mentioned field effect mobility.

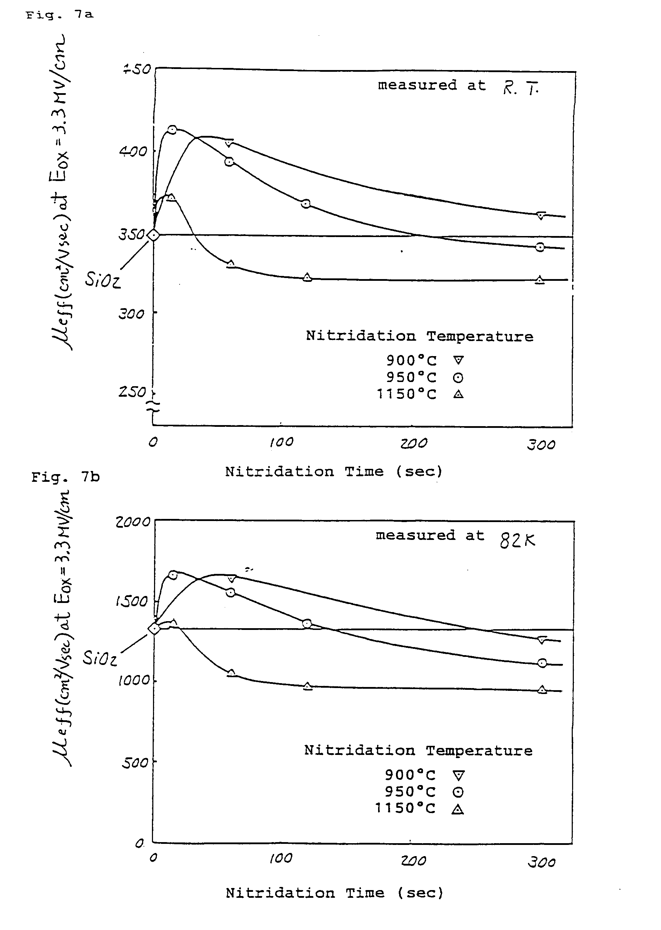

In Figures 7a and 7b, the effective mobility in a high vertical electric field of 3.3 MV/cm at room temperature and at 82 K are plotted against the nitridation time for examination of their dependency on nitriding conditions. The effective mobility $\mu_{eff}$ is defined as follows:

$$\mu_{eff} = \frac{L}{W} \cdot \frac{1}{V_D} \cdot \frac{1}{C_i} \cdot \frac{I_D}{(V_G - V_T)}$$

In contrast to the field effect mobility $\mu_{FE}$ mentioned above, the effective mobility $\mu_{eff}$ is considered as a mobility for large signals and hence considered to represent the actually measured circuit operation speed more accurately. The effective mobility is affected by both the maximum field effect mobility $\mu_{FEmax}$ and the field effect mobility $\mu_{FE}$ in a high electric field. The relationship between the effective mobility $\mu_{eff}$ and the maximum field effect mobility $\mu_{FEmax}$ and field effect mobility $\mu_{FE}$ in a high electric field can be derived as follows:

$$\mu_{eff} = \frac{\mu_{FEmax} \cdot (V_G - V_T)_{max} + \int_{(V_G-V_T)_{max}}^{V_G-V_T} \mu_{FE}\, dV}{V_G - V_T}$$

where $(V_G-V_T)_{max}$ is the gate driving voltage at the time when $\mu_{FEmax}$ is obtained. It can be seen from Figure 7a that at each nitridation temperature, the effective mobility shows an increase at first, reaches a maximum after a certain nitridation time, and then gradually decreases. A higher nitridation temperature causes this tendency to progress in a shorter time. With lighter nitriding conditions, for example, with a shorter nitridation time, the improvement of the field effect mobility in a high electric field is obtained in a very short time as compared to the deterioration of the maximum field effect mobility as shown in Figure 6, thus improving the effective mobility as compared to the oxide film and resulting in a larger driving current. On the other hand, with heavier nitriding conditions, for example, with a longer nitridation time, the effect of the deterioration of the maximum field effect mobility becomes dominant, which causes the effective mobility to become smaller than that of the oxide film, thus resulting in the deterioration of the driving current. Figure 7b shows that the same tendency as observed at room temperature applied to the case measured at 82 K. However, the range of the nitridation time in which a greater effective mobility than the oxide film is obtained becomes narrow and strict as compared to the case at room temperature.

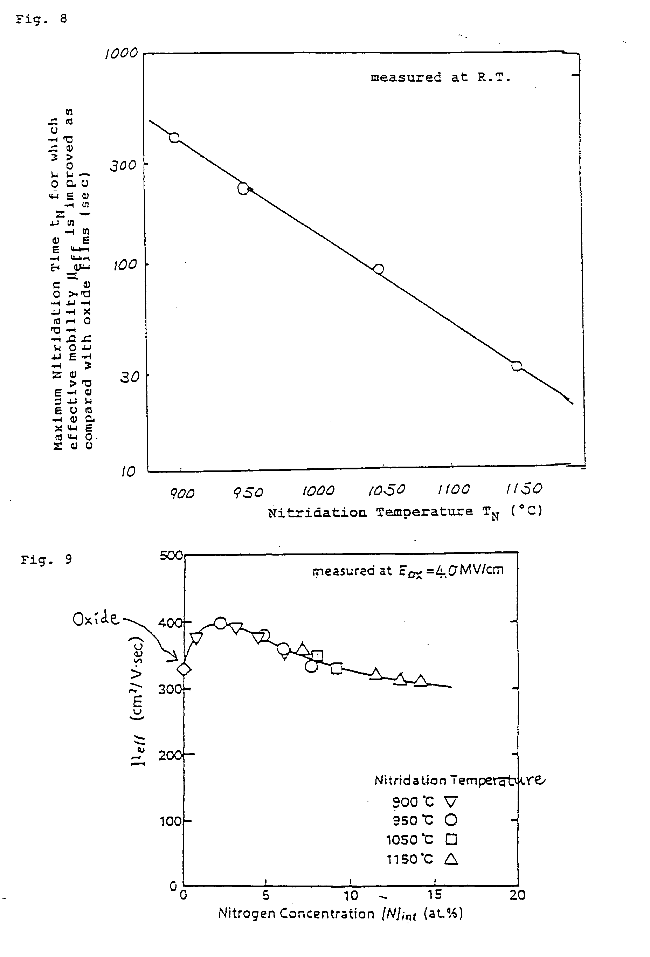

In Figure 8, the maximum nitridation time $t_N$ (sec) which accomplishes the improvement of effective mobility as compared to the oxide film is plotted against the nitridation temperature $T_N$ ($^{o}$C). It can be seen from Figure 8 that the relationship $t_N = 10^{6.6-T_N/225}$ is established at room temperature. This means that the nitridation time of $10^{6.6-T_N/225}$ or shorter should be chosen to form the nitride oxide film in order to accomplish a circuit operation speed as compared to the oxide film.

Figure 9 shows a graph of the effective mobility $\mu_{eff}$ in a high vertical electric field of 4.0 MV/cm, which is measured by Auger spectroscopy, against the nitrogen concentration $[N]_{int}$ in the vicinity of the interface between the insulating film and the substrate. The nitride oxide film used as a gate insulating film of the MOS field-effect device was formed by heating in an atmosphere of ammonia gas for a short time with the use of a short-time heating furnace. It can be seen from Figure 9 that the effective mobility $\mu_{eff}$ shows an increase at first as the nitrogen concentration $[N]_{int}$ increases, reaches a maximum at a concentration of around 2 to 3 atomic %, and then monotonously decreases. It can also be seen from this figure that a nitride oxide film having a nitrogen concentration $[N]_{int}$ of about 8 atomic % or less can be used to obtain an improved effective mobility in a high electric field useful for operation in an actual circuit, as compared to the thermal oxide film.

As described above, according to the present invention, an insulating film having a high mobility can be obtained by an extremely simple method. With the use of such an insulating film in a minute MOS device, the deterioration of mobility in a high vertical electric field can be significantly reduced, thus offering useful advantages of a higher current driving capability and a faster circuit operating speed in practical use.

It is understood that various other modifications will be apparent to and can be readily made by those skilled in the art without departing from the scope and spirit of this invention. Accordingly, it is not intended that the scope of the claims appended hereto be limited to the description as set forth herein, but rather that the claims be construed as encompassing all the features of patentable novelty that reside in the present invention, including all features that would be treated as equivalents thereof by those skilled in the art to which this invention pertains.

**Claims**

1. In a semiconductor device comprising a semiconductor substrate and an insulating film disposed on said substrate, wherein said insulating film is a nitride oxide film prepared by nitriding a thermal oxide film, which has been formed on said substrate, in an atmosphere of nitriding gas for a nitridation time of $10^{6.6-T_N/225}$ seconds or shorter wherein $T_N$ is the nitridation temperature in degree centigrade.

2. A semiconductor device according to claim 1, wherein said nitride oxide film is used as a gate insulating film.

3. In a semiconductor device comprising a semiconductor substrate and an insulating film disposed on said substrate, wherein said insulating film is a nitride oxide film prepared by nitriding a thermal oxide film, which has been formed on said substrate, so as to have a nitrogen concentration of about 8 atomic % or less, at least in the vicinity of the interface between the nitride oxide film and the substrate.

4. A semiconductor device according to claim 3, wherein said nitride oxide film is used as a gate insulating film.

5. A method for the production of a semiconductor device comprising the steps of forming a thermal oxide film on said substrate and nitriding said thermal oxide film in an atmosphere of nitriding gas for a nitridation time of $10^{6.6-T_N/225}$ seconds or shorter wherein $T_N$ is the nitridation temperature in degree centigrade.

6. A method for the production of a semiconductor device according to claim 5, wherein rapid heating by means of radiation is used in said nitriding step.

7. A method for the production of a semiconductor device comprising the steps of forming a thermal oxide film on said substrate and nitriding said thermal oxide film in an atmosphere of nitriding gas so as to have a nitrogen concentration of about 8 atomic % or less, at least in the vicinity of the interface between the nitride oxide film and the substrate.

8. A method for the production of a semiconductor device according to claim 7, wherein rapid heating by means of radiation is used in said nitriding step.

9. A method for the production of a semiconductor device comprising a semiconductor substrate comprising the steps of forming a thermal oxide film on said substrate and nitriding said thermal oxide film in an atmosphere of nitriding gas so as to have a peak nitrogen concentration of about 8 atomic % or less at the point nearest the interface between the oxynitride film and the substrate.

10. A method for the production of a semiconductor device according to claim 9, wherein rapid heating by means of radiation is used in said nitriding step.

11. A method of operating a semiconductor device, the semiconductor device comprising:
    a semiconductor substrate (1);
    an insulating film (3) formed over the substrate (1);
    a gate electrode (5) disposed on the insulating film (3); and
    a drain (6) and a source (6), the drain (6) and the source (6) being formed in the substrate (1),
    the insulating film (3) being a nitride oxide film prepared by nitriding a thermal oxide film (2) formed on the substrate (1) in an atmosphere of nitriding gas for a nitriding time of $10^{6.6-T_N/225}$ seconds or shorter wherein $T_N$ is the nitridation temperature in degrees centigrade and wherein $900\,^{\circ}\text{C} \leq T_N \leq 1150\,^{\circ}\text{C}$;
    wherein the semiconductor device is operated at a gate driving voltage ($V_G$-$V_T$) which gives an electric field (E) across the nitride oxide film in the following range:

    $2\ \text{MV/cm} \leq E.$

12. A method of operating a semiconductor device, the semiconductor device comprising:
    a semiconductor substrate (1);

an insulating film (3) formed over the substrate (1);

a gate electrode (5) disposed on the insulating film (3); and

a drain (6) and a source (6), the drain (6) and the source (6) being formed in the substrate (1),

the insulating film (3) being a nitride oxide film prepared by nitriding a thermal oxide film (2) formed on the substrate (1) in an atmosphere of nitriding gas for a nitriding time of $10^{6.6-T_N/225}$ seconds or shorter wherein $T_N$ is the nitridation temperature in degrees centigrade and wherein $900°C \leq T_N \leq 1150°C$;

wherein the semiconductor device is operated at a gate driving voltage $(V_G-V_T)$ which gives an electric field (E) across the nitride oxide film in the following range:

$$2 \text{ MV/cm} \leq E \leq 7 \text{ MV/cm}.$$

13. A method of operating a semiconductor device, the semiconductor device comprising a semiconductor substrate (1) and an insulating film (3) disposed on the substrate (1), the insulating film (3) being a nitride oxide film prepared by nitriding a thermal oxide film (2) formed on the substrate (1) in an atmosphere of nitriding gas for a nitriding time of $10^{6.6-T_N/225}$ seconds or shorter wherein $T_N$ is the nitridation temperature in degrees centigrade and wherein $900°C \leq T_N \leq 1150°C$;

wherein the semiconductor device is operated at a gate driving voltage $(V_G-V_T)$ which gives an electric field (E) across the layer in the following range:

$$4 \text{ MV/cm} \leq E \leq 7 \text{ MV/cm}.$$

14. A method of operating a semiconductor device, the semiconductor device comprising a semiconductor substrate (1) and an insulating film (3) disposed on the substrate (1), the insulating film (3) being a nitride oxide film prepared by nitriding a thermal oxide film (2) formed on the substrate (1) in an atmosphere of nitriding gas so as to have a nitrogen concentration of around 8 atomic % or less, at least in the vicinity of an interface between the nitride oxide film (3) and the substrate (1);

wherein the semiconductor device is operated at a gate driving voltage $(V_G-V_T)$ which gives an electric field (E) across the layer in the following range:

$$2 \text{ MV/cm} \leq E.$$

15. A method of operating a semiconductor device, the semiconductor device comprising a semiconductor substrate (1) and an insulating film (3) disposed on the substrate (1), the insulating film (3) being a nitride oxide film prepared by nitriding a thermal oxide film (2) formed on the substrate (1) in an atmosphere of nitriding gas so as to have a nitrogen concentration of around 8 atomic % or less, at least in the vicinity of an interface between the nitride oxide film (3) and the substrate (1);

wherein the semiconductor device is operated at a gate driving voltage $(V_G-V_T)$ which gives an electric field (E) across the layer in the following range:

$$2 \text{ MV/cm} \leq E \leq 7 \text{ MV/cm}.$$

16. A method of operating a semiconductor device, the semiconductor device comprising a semiconductor substrate (1) and an insulating film (3) disposed on the substrate (1), the insulating film (3) being a nitride oxide film prepared by nitriding a thermal oxide film (2) formed on the substrate (1) in an atmosphere of nitriding gas so as to have a nitrogen concentration of around 8 atomic % or less, at least in the vicinity of an interface between the nitride oxide film (3) and the substrate (1);

wherein the semiconductor device is operated at a gate driving voltage $(V_G-V_T)$ which gives an electric field (E) across the layer in the following range:

$$4 \text{ MV/cm} \leq E \leq 7 \text{ MV/cm}.$$

17. A method of operating a semiconductor device as claimed in claim 11, 12, 13, 14, 15 or 16 wherein the semiconductor device is operated at room temperature.

18. A method of operating a semiconductor device as claimed in claim 11, 12, 13, 14, 15 or 16 wherein the semiconductor device is operated at a temperature near to the boiling point of nitrogen.

19. A semiconductor device comprising:

a semiconductor substrate (1);

an insulating film (3) formed over the substrate (1);

a gate electrode (5) disposed on the insulating film (3); and

a drain (6) and a source (6), the drain (6) and the source (6) being formed in the substrate (1);

the semiconductor device being characterized in that the insulating film (3) is a nitride oxide film prepared by nitriding a thermal oxide film (2) formed on the substrate (1) in an atmosphere of nitriding gas for a nitriding time of $10^{6.6-T_N/225}$ seconds or shorter wherein $T_N$ is the nitridation temperature in degrees centigrade and wherein $900°C \leq T_N \leq 1150°C$.

20. A semiconductor device comprising:

a semiconductor substrate (1);

an insulating film (3) formed over the substrate (1);

a gate electrode (5) disposed on the insulating film (3); and

a drain (6) and a source (6), the drain (6) and the source (6) being formed in the substrate (1);

the semiconductor device being characterized in that the insulating film (3) is a nitride oxide film prepared by nitriding a thermal oxide film (2) formed on the substrate (1) in an atmosphere of nitriding gas so as to have a nitrogen concentration of around 8 atomic % or less, at least in the vicinity of an interface between the nitride oxide film (3) and the substrate (1).

21. A method of manufacturing a semiconductor device comprising the steps of:

forming an insulating film (3) on a semiconductor substrate (1);

forming a gate electrode (5) on the insulating film (3); and

forming a drain (6) and a source (6) in the semiconductor substrate (1);

the method being characterized in that the insulating film is formed by nitriding a thermal oxide film (2) formed on the substrate (1) in an atmosphere of nitriding gas for a nitriding time of $10^{6.6-T_N/225}$ seconds or shorter wherein $T_N$ is the nitridation temperature in degrees centigrade and wherein $900°C \leq T_N \leq 1150°C$.

22. A method of manufacturing a semiconductor device comprising the steps of:

forming an insulating film (3) on a semiconductor substrate (1);

forming a gate electrode (5) on the insulating film (3); and

forming a drain (6) and a source (6) in the semiconductor substrate (1);

the method being characterized in that the insulating film is formed by nitriding a thermal oxide film (2) formed on the substrate (1) in an atmosphere of nitriding gas so as to have a nitrogen concentration of around 8 atomic % or less, at least in the vicinity of an interface between the nitride oxide film (3) and the substrate (1).

23. A method as claimed in claim 21 or 22, wherein rapid heating by means of radiation is used in the nitriding step.

Fig. 1a

Fig. 1b

Fig. 1c

Fig. 1d

Fig. 1e

Fig. 1f

Fig. 2

Fig. 3a

Fig. 3b

Fig. 4a

Graph — x-axis: Gate Driving Voltage $V_G-V_T$ (V); y-axis: Drain Current $I_D$ ($\mu A$). Annotation "measured at 82K". Legend: Oxide (solid), NO (dashed).

Fig. 4b

Graph — x-axis: Gate Driving Voltage $V_G-V_T$ (V); y-axis: Transconductance $g_m$ ($\mu sec$). Annotation "measured at 82K". Legend: Oxide (solid), No (dashed).

Fig. 5a

Fig. 5b

Fig. 6a

Fig. 6b

EP 0 585 972 A2

Fig. 7a

measured at R. T.

Nitridation Temperature

900°C ▽
950°C ⊙
1150°C △

Nitridation Time (sec)

Fig. 7b

measured at 82K

Nitridation Temperature

900°C ▽
950°C ⊙
1150°C △

Nitridation Time (sec)

17

Fig. 8

Fig. 9